Europäisches Patentamt

European Patent Office

Office européen des brevets

(11) Veröffentlichungsnummer: **0 283 677 B1**

(12) **EUROPÄISCHE PATENTSCHRIFT**

(45) Veröffentlichungstag der Patentschrift: **13.05.92**

(21) Anmeldenummer: **88101348.6**

(22) Anmeldetag: **30.01.88**

(51) Int. Cl.⁵: **H05K 7/20**

(54) **Elektrische Baueinheit.**

(30) Priorität: **26.03.87 DE 8704499 U**

(43) Veröffentlichungstag der Anmeldung:
**28.09.88 Patentblatt 88/39**

(45) Bekanntmachung des Hinweises auf die
Patenterteilung:
**13.05.92 Patentblatt 92/20**

(84) Benannte Vertragsstaaten:
**AT BE CH DE FR GB LI NL**

(56) Entgegenhaltungen:
**DE-A- 2 608 125**
**DE-A- 3 416 348**
**DE-U- 8 027 160**
**DE-U- 8 413 596**
**DE-U- 8 515 414**

(73) Patentinhaber: **Licentia Patent-**
**Verwaltungs-GmbH**
**Theodor-Stern-Kai 1**
**W-6000 Frankturt/Main 70(DE)**

(72) Erfinder: **Strünkmann, Jörg**
**Josef-Löbecke-Strasse 16**
**W-4788 Warstein-Belecke(DE)**
Erfinder: **Lenze, Friedel**
**Kirchtal 17**
**W-4784 Büthen-Altenrüthen(DE)**

(74) Vertreter: **Lertes, Kurt, Dr. et al**
**Licentia Patent-Verwaltungs-GmbH Theodor-**
**Stern-Kai 1**
**W-6000 Frankturt/M 70(DE)**

## Beschreibung

Die Erfindung betrifft eine elektrische Baueinheit mit einem Kühlkörper, einem mit Halbleiterbauelementen bestückten, mit dem Kühlkörper verbundenen Leistungsblock mit mindestens zwei Anschlüssen, mindestens einer Sicherung für den Leistungsblock und mit einer Leiterplatte zur Aufnahme und Verschaltung elektronischer Bauelemente.

Derartige Baueinheiten werden z. B. als Leistungssteller für die verschiedensten Anwendungszwecke ausgelegt und sind beispielsweise aus dem Firmenprospekt "Leistungssteller" der AEG Aktiengesellschaft, 1986, bekannt. Ein Leistungssteller besteht in der Regel aus Thyristoren, die beispielsweise im Phasenanschnitt angesteuert werden. Die Thyristoren sind zu einer Baueinheit, dem Leistungsblock, zusammengefaßt, der seinerseits auf einem Kühlkörper befestigt ist. Der Leistungssteller enthält ferner mindestens eine Sicherung für die Thyristoren und eine Steuereinrichtung zum Betrieb der Thyristoren.

Die den Leistungssteller bildenden Komponenten einschließlich des Kühlkörpers wurden bisher in einem Gehäuse zu einer Baueinheit zusammengefaßt, derart, daß der Kühlkörper mit dem Leistungsblock, die Sicherung sowie die Leiterplatte in einem Gehäuse untergebracht waren. Da insbesondere für den Kühlkörper ein nicht zu unterschreitender Raumbedarf verfügbar sein mußte, müssen relativ große Gehäuse in Kauf genommen werden, bei denen zusätzlich noch für eine ausreichende Belüftung des Kühlkörpers Sorge zu tragen ist.

Aus DE-A-3 416 348 ist ferner eine Kompaktbaugruppe bekannt, die aus einer einseitig mit elektrischen Bauteilen bestückten Leiterplatte und einem Gehäuse Kühlkörper gebildet wird.

Der Erfindung liegt die Aufgabe zugrunde, eine Baueinheit der eingangs definierten Art derart auszubilden, daß die gleichen Komponenten raumsparender und mit geringerem Montageaufwand angeordnet bzw. untergebracht werden können und eine schmale Bauform realisiert werden kann.

Diese Aufgabe wird gemäß der Erfindung dadurch gelöst, daß der Kühlkörper L-förmig ausgebildet ist und seine beiden Innenflächen Gehäusewandungen sind.

Der L-förmige Ausschnitt des Körpers bildet bei der Erfindung selbst das Gehäuseinnere, wobei die mit Kühlrippen versehenen Außenseiten des Kühlkörpers direkt der Umgebungsluft ausgesetzt sind. Der L-förmige Ausschnitt des Kühlkörpers läßt sich in einfacher Weise zur Vervollständigung des Gehäuses abdecken. Ein weiterer Vorteil der Erfindung besteht darin, daß mehrere Baueinheiten sich zu einer Baugruppe zusammenfassen lassen derart, daß die Kühlrippen zweier Baueinheiten ohne Abstand aneinanderstoßen oder bei entsprechend angeordneten Kühlrippen überlappend ineinander greifen, wobei für die Baugruppe ein raumsparender Aufbau bei guter Kühlwirkung ermöglicht wird.

Weiterbildungen der Erfindung sind den Unteransprüchen zu entnehmen.

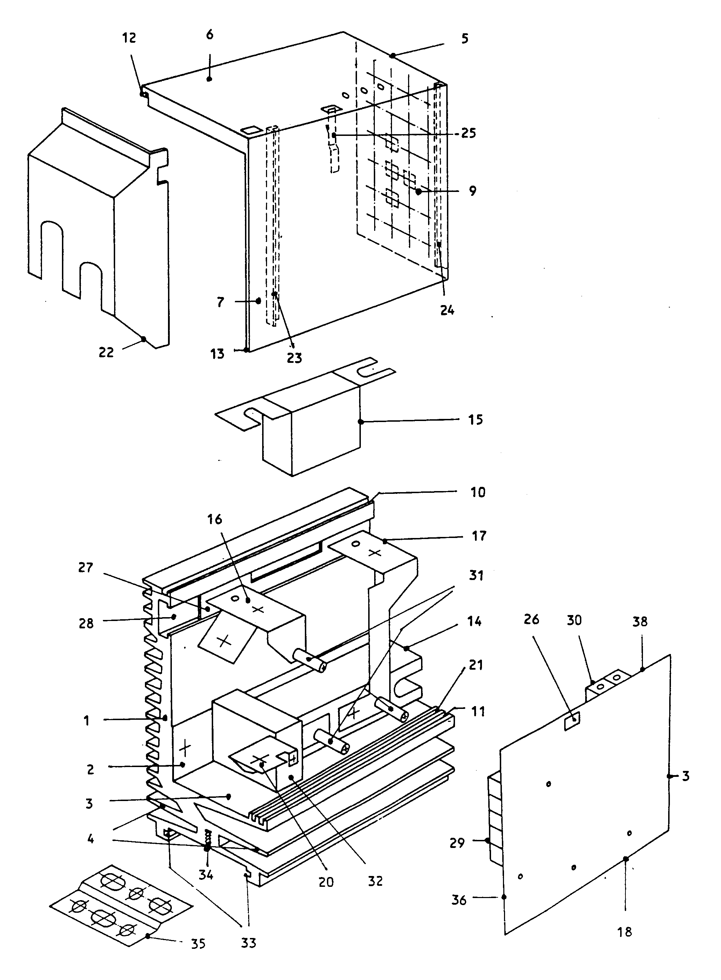

Das Wesen der Erfindung soll anhand der Zeichnung näher erläutert werden. Die Zeichnung zeigt eine Explosionsdarstellung einer Baueinheit gemäß der Erfindung.

Der Kühlkörper 1 weist einen L-förmigen Ausschnitt auf, wobei die beiden Innenwandungen 2 und 3 des Kühlkörpers gleichzeitig Gehäusewandungen sind. Auf den beiden Außenseiten des Kühlkörpers sind Kühlrippen 4 vorgesehen. Zur Vervollständigung des Gehäuses ist eine L-förmige Abdeckhaube 5 vorgesehen, deren Abmessungen dem L-förmigen Ausschnitt des Kühlkörpers entsprechen. Die beiden Innenwandungen 2 und 3 des Kühlkörpers sowie die Seitenteile 6 und 7 der Abdeckhaube 5 ergänzen sich zu einem rechteckförmigen Gehäuseteil, das zunächst noch auf zwei gegenüberliegenden Seiten offen ist. Ein allseitig geschlossenes Gehäuse läßt sich beispielsweise dadurch erzielen, daß senkrecht zu der L-förmigen Begrenzung der Abdeckhaube beidseitig zwei weitere Gehäusewandungen vorgesehen sind, die einstückig mit der Abdeckhaube ausgebildet sein können. In der Figur ist die Abdeckhaube 5 mit einer weiteren Gehäusewandung 9 versehen, die als Schutzgitter ausgeführt ist. Das Gehäuse wird vervollständigt durch eine separate schalenförmige Gehäusewand 22, die in die Abdeckhaube 5 eingeschoben wird und durch diese gehalten wird. An den beiden Längsseiten des Kühlkörpers 1 sind je eine Nut 10 bzw. 11 eingeformt, in die entsprechend angeformte Ansätze 12 und 13 der Abdeckhaube 5 eingreifen und dabei eine formschlüssige Verbindung zwischen der Abdeckhaube und dem Kühlkörper herstellen. Die Haube hat zwei innenliegende Führungsnuten 23, 24, die um die Kanten 36, 37 einer Leiterplatte 18 fassen, so daß sie von vorn in den L-förmigen Kühlkörperausschnitt geführt wird. Ein innenliegender federnder Verriegelungshaken 25, der von außen zum Entriegeln zugänglich ist, greift in einen Durchbruch 26 der Leiterplatte 18 und verriegelt die Haube 5.

Ein Leistungsblock 14 ist an der größeren Innenwandung 2 des Kühlkörpers 1 befestigt. In dem Ausführungsbeispiel erstreckt sich der Leistungsblock in Längsrichtung der Innenwandung des Kühlkörpers. Oberhalb des Leistungsblocks 14 ist eine Sicherung 15 angeordnet, die von Leistungsschienen 16 und 17 derart gehalten wird, daß sie von vorn her in den Gehäuseausschnitt des Kühlkörpers eingeschoben werden kann.

Die Schienen 16 und 17 werden durch ein Isolierteil 27 untereinander als auch mit dem Kühlkörper verbunden, wobei das Isolierteil in eine auf der Innenwandung 2 des Kühlkörpers 1 eingearbeitete Nut 28 eingeschoben und verankert ist.

Die Leiterplatte 18 ist in dem L-förmigen Ausschnitt des Kühlkörpers parallel zu der Gehäusewandung 7 der Abdeckhaube 5 angeordnet. Nicht weiter dargestellte elektronische Bauelemente der Leiterplatte sind auf dieser gehäuseinnenseitig angeordnet. An der Kante 36 der Leiterplatte 18 sind Anschlußelemente 29 vorgesehen, die zur Herstellung äußerer Anschlüsse, z. B. mittels Stecker dienen. An der Kante 38 der Leiterplatte 18 sind Anzeige- und Bedienelemente 30 der elektrischen Baueinheit befestigt. Die Leiterplatte 18 wird über Anschlußbolzen 31 mechanisch und elektrisch mit dem Leistungsblock 14 und den Schienen 16, 17 verbunden, wobei die Bolzen 31 gleichzeitig die Schienen mit den Anschlüssen des Leistungsblocks 14 verbinden. Zusätzlich greift die Leiterplatte 18 in eine Nut 21 des Kühlkörpers 1, wodurch sie mechanisch für die isolierende Abstützung einer Schiene 20 stabilisiert wird. Auf die Schiene 20 kann ein Stromwandler 32 gesetzt werden.

Der Kühlkörper 1 hat an der Rückseite Führungsnuten 33 und eine Gewindespur 34 zur Aufnahme von Befestigungslaschen 35 und/oder nicht weiter dargestellten Schnappbefestigungen für Montageschienen.

Referenzliste

| | |
|---|---|
| 1 | Kühlkörper |
| 2, 3 | Innenflächen des Kühlkörpers |
| 4 | Kühlrippen des Kühlkörpers |
| 5 | Abdeckhaube (Gehäusewandungen) |
| 6, 7 | Seitenteile der Abdeckhaube als Gehäusewandungen |
| 9 | weitere Gehäusewandung |
| 10, 11 | Nuten im Kühlkörper zur Aufnahme der Abdeckhaube |
| 12, 13 | Ansätze an Abdeckhaube |
| 14 | Leistungsblock |
| 15 | Sicherung |
| 16, 17 | Halterungsschienen für Sicherung |
| 18 | Leiterplatte |
| 20 | Schiene |
| 21 | Aufnahmenut für Leiterplatte |
| 22 | Abdeckung des Gehäuseanschlußbereiches |
| 23, 24 | Führungsnuten in der Haube |
| 25 | Verriegelungshaken |
| 26 | Leiterplattendurchbruch |
| 27 | Isolierteil |
| 28 | Nut im Kühlkörper zur Aufnahme des Isolierteiles |
| 29 | Anschlußelemente |
| 30 | Anzeige- und Bedienelemente |
| 31 | Anschlußbolzen |
| 32 | Stromwandler |
| 33 | Nuten im Kühlkörper zur Aufnahme von Befestigungslaschen |
| 34 | Gewindespur |
| 35 | Befestigungsteil |

**Patentansprüche**

1. Elektrische Baueinheit mit einem Kühlkörper (1), einem mit Halbleiterbauelementen bestückten, mit dem Kühlkörper verbundenen Leistungsblock (14) mit mindestens zwei Anschlüssen, mindestens einer Sicherung (15) für den Leistungsblock und mit einer Leiterplatte (18) zur Aufnahme und Verschaltung elektronischer Bauelemente, wobei die Baueinheit eingehäust ist,
**dadurch gekennzeichnet,**
daß der Kühlkörper (1) L-förmig ausgebildet ist und beide Innenflächen (2, 3) Gehäusewandungen sind.

2. Baueinheit nach Anspruch 1,
**gekennzeichnet durch**
eine L-förmige Abdeckhaube (5), deren Abmessungen dem L-förmigen Ausschnitt des Kühlkörpers (1) entsprechen und die zwei weitere Gehäusewandungen (6, 7) bildet, die den entsprechenden Gehäusewandungen (2, 3) des Kühlkörpers gegenüberstehen und mit diesen ein rechteckförmiges Gehäuseteil bilden.

3. Baueinheit nach Anspruch 2,
**dadurch gekennzeichnet,**
daß die Abdeckhaube (5) senkrecht zu ihrem L-förmigen Profil eine weitere Gehäusewandung (9) aufweist, deren Abmessungen dem rechteckförmigen Querschnitt des Gehäuseteils entsprechen.

4. Baueinheit nach Anspruch 3,
**dadurch gekennzeichnet,**
daß auf der der Gehäusewandung (9) gegenüberliegenden Seite in entsprechender Weise eine weitere Gehäusewandung vorgesehen ist, wobei die Abdeckhaube (5) und die Gehäusewandungen einstückig ausgebildet sind.

5. Baueinheit nach Anspruch 3,
**dadurch gekennzeichnet,**
daß die Abdeckhaube (5) am der Gehäusewand (9) gegenüberliegenden Randbereich Aufnahmen und eine Verriegelung für eine separate Gehäusewand (22) aufweist.

**6.** Baueinheit nach Anspruch 3,
**dadurch gekennzeichnet,**
daß in der Gehäusewandung (9) Durchbrüche vorgesehen sind.

**7.** Baueinheit nach Anspruch 2,
**dadurch gekennzeichnet,**
daß die Gehäusewand (7) der Abdeckhaube (5) innenliegend Führungsnuten (23, 24) aufweist, die um gegenüberliegende Kanten (36, 37) einer Leiterplatte (18) fassen.

**8.** Baueinheit nach Anspruch 7,
**dadurch gekennzeichnet,**
daß die Gehäusewand (7) innenliegend einen federnden Verriegelungshaken (25) aufweist, der in einen in der Leiterplatte (18) vorgesehenen Durchbruch (26) faßt.

**9.** Baueinheit nach einem der Ansprüche 2 bis 5,
**dadurch gekennzeichnet,**
daß der Kühlkörper (1) an seinen beiden gehäuseseitigen Längskanten jeweils eine Nut (10, 11) aufweist, in die ein entsprechend angeformter Ansatz (12, 13) der Abdeckhaube (5) eingreift.

**10.** Baueinheit nach einem der Ansprüche 1 bis 9,
**dadurch gekennzeichnet,**
daß der Leistungsblock (14) auf der größeren Innenfläche (2) des Kühlkörpers (1) befestigt ist.

**11.** Baueinheit nach Anspruch 10,
**dadurch gekennzeichnet,**
daß auf der der kleineren Innenfläche (3) des Kühlkörpers abgewandten Seite des Leistungsblock (14) die Sicherung (15) angeordnet ist.

**12.** Baueinheit nach Anspruch 11,
**dadurch gekennzeichnet,**
daß die Sicherung (15) an zwei abgewinkelten Schienen (16, 17) befestigt ist, die über ein Isolierteil (27) in ein Haltenut (28) des Kühlkörpers (1) eingreifen.

**13.** Baueinheit nach einem der Ansprüche 10 bis 12,
**dadurch gekennzeichnet,**
daß auf der der Innenfläche (2) des Kühlkörpers (1) abgewandten Seite des Leistungsblocks (14) die elektrische Verschienung des Leistungsbauteils angeordnet ist.

**14.** Baueinheit nach einem der Ansprüche 1 bis 13,
**dadurch gekennzeichnet,**
daß die Leiterplatte (18) parallel zu der der größeren Kühlkörperwandung (2) gegenüberliegenden äußeren Gehäusewandung (7) der Abdeckhaube (5) an diese anschließend angeordnet ist.

**15.** Baueinheit nach Anspruch 14,
**dadurch gekennzeichnet,**
daß elektronische Bauelemente auf der der Abdeckhaube (5) abgewandten Seite der Leiterplatte (18) angeordnet sind.

**16.** Baueinheit nach Anspruch 14 oder 15,
**dadurch gekennzeichnet,**
daß an eine Kante (38) der Leiterplatte (18) Anzeige- und Bedienteile (30) angeordnet sind.

**17.** Baueinheit nach Anspruch 16,
**dadurch gekennzeichnet,**
daß an einer weiteren Kante (36) der Leiterplatte (18) Anschlußelemente (29) für äußere Anschlüsse vorgesehen sind.

**18.** Baueinheit nach einem der Ansprüche 14 bis 17,
**dadurch gekennzeichnet,**
daß der Kühlkörper (1) an seiner an die Leiterplatte (18) angrenzenden Innenfläche (3) eine Nut (21) zur Aufnahme der Leiterplatte (18) aufweist.

**19.** Baueinheit nach Anspruch 1,
**dadurch gekennzeichnet,**
daß der Kühlkörper (1) an der Außenfläche einer Wandung (3) Nuten (33) zur Aufnahme von Befestigungsteilen (35) aufweist.

**Claims**

**1.** Electrical sub-assembly with a cooling body (1), a power output block (14), which is equipped with semiconductor components and connected with the cooling body, with at least two terminals, at least one fuse (15) for the power output block and with a circuit board (18) for the reception and interconnection of electronic components, wherein the sub-assembly is in a housing, characterised thereby, that the cooling body (1) is constructed in L-shape and both inward surfaces (2, 3) are housing walls.

**2.** Sub-assembly according to claim 1, characterised by an L-shaped cover hood (5), the dimensions of which correspond with the L-shaped cut-out of the cooling body (1) and which forms two further housing walls (6, 7), which stand opposite the corresponding housing walls (2, 3) of the cooling body and together with these form a rectangular housing part.

3. Sub-assembly according to claim 2, characterised, thereby that, the cover hood (5) perpendicularly to its L-shaped profile displays a further housing wall (9), the dimensions of which correspond with the rectangular cross-section of the housing part.

4. Sub-assembly according to claim 3, characterised thereby, that a further housing wall is provided in corresponding manner on the side lying opposite the housing wall (9), wherein the cover hood (5) and the housing walls are constructed integrally.

5. Sub-assembly according to claim 3, characterised thereby, that the cover hood (5) at the rim region lying opposite the housing wall (9) displays receptacles and a latching for a separate housing wall (22).

6. Sub-assembly according to claim 3, characterised thereby, that passages are provided in the housing wall (9).

7. Sub-assembly according to claim 2, characterised thereby, that the housing wall (7) of the cover hood (5) inwardly displays guide grooves (23, 24), which engage around opposite edges (36, 37) of a circuit board (18).

8. Sub-assembly according to claim 7, characterised thereby, that the housing wall (7) inwardly displays a resilient latching hook (25), which engages into a passage (26) provided in the circuit board (18).

9. Sub-assembly according to one of the claims 2 to 5, characterised thereby, that the cooling body (1) at each of both its longitudinal edges at the housing side displays a respective groove (10, 11), into which a correspondingly shaped projection (12, 13) of the cover hood (5) engages.

10. Sub-assembly according to one of the claims 1 to 9, characterised thereby, that the power output block (14) is fastened on the larger inward surface (2) of the cooling body (1).

11. Sub-assembly according to claim 10, characterised thereby, that the fuse (15) is arranged on that side of the power output block (14), which is remote from the smaller inward surface (3) of the cooling body.

12. Sub-assembly according to claim 11, characterised thereby, that the fuse (15) is fastened at two bent-over rails (16, 17), which engage by way of an insulating part (27) into a retaining groove (28) of the cooling body (1).

13. Sub-assembly according to one of the claims 10 to 12, characterised thereby, that the electrical rails of the power output component are arranged on that side of the power output block (14), which is remote from the inward surface (2) of the cooling body (1).

14. Sub-assembly according to one of the claims 1 to 13, characterised thereby, that the circuit board (18) is arranged parallelly to and adjoining that outward housing wall (7) of the cover hood (5), which lies opposite the larger cooling body wall (2).

15. Sub-assembly according to claim 14, characterised thereby, that electronic components are arranged on that side of the circuit board (18), which is remote from the cover hood (5).

16. Sub-assembly according to claim 14 or 15, characterised thereby, that indicating and operating parts (30) are arranged at one edge (38) of the circuit board (18).

17. Sub-assembly according to claim 16, characterised thereby, that terminal elements (29) for external connections are provided at a further edge (38) of the circuit board (18).

18. Sub-assembly according to one of the claims 14 to 17, characterised thereby, that the cooling body (1) at its inward surface (3) adjoining the circuit board (18) displays a groove (21) for the reception of the circuit board (18).

19. Sub-assembly according to claim 1, characterised thereby, that the cooling body (1) at the outward surface of one wall (3) displays grooves (33) for the reception of fastening parts (35).

**Revendications**

1. Unité de construction électrique munie d'un refroidisseur (1), d'un bloc de puissance (14) équipé de composants à semi-conducteurs et relié au refroidisseur, et munie au moins de deux connexions, au moins d'un fusible de sécurité (15) pour le bloc de puissance et munie d'une carte imprimée (18) destinée au logement et au câblage de composants électroniques, l'unité de construction étant enencastrée, caractérisée en ce que le refroidisseur (1) est conçu en L et en ce que les deux surfaces intérieures (2, 3) sont des parois de boîtier.

2. Unité de construction selon la revendication 1, caractérisée par un couvercle en L (5) dont les dimensions correspondent à la coupe en L du refroidisseur (1) et qui forme deux parois supplémentaires de boîtier (6, 7) qui se trouvent face aux parois de boîtier correspondantes (2, 3) du refroidisseur et forment avec celles-ci une partie de boîtier rectangulaire.

3. Unité de construction selon la revendication 2, caractérisée en ce que le couvercle (5) présente, verticalement à son profil en L, une paroi supplémentaire de boîtier (9) dont les dimensions correspondent à la section rectangulaire de la pièce du boîtier.

4. Unité de construction selon la revendication 3, caractérisée en ce qu'une paroi supplémentaire de boîtier est prévue de façon correspondante sur le côté opposé à la paroi de boîtier (9), le couvercle (5) et les parois de boîtier étant conçus d'un seul tenant.

5. Unité de construction selon la revendication 3, caractérisée en ce que le couvercle (5) présente, sur la zone du bord, opposée à la paroi de boîtier 9, des logements et un verrouillage pour une paroi de boîtier séparée (22).

6. Unité de construction selon la revendication 3, caractérisée en ce que des ouvertures sont prévues dans la paroi de boîtier (9).

7. Unité de construction selon la revendication 2, caractérisée en ce que la paroi de boîtier (7) du couvercle (5) présente, à l'intérieur, des rainures de guidage (23, 24) qui entourent les bords opposés (36, 37) d'une carte imprimée (18).

8. Unité de construction selon la revendication 7, caractérisée en ce que la paroi de boîtier (7) présente, à l'intérieur, un crochet de verrouillage à ressort (25) qui s'enfonce dans une ouverture (26) prévue dans la carte imprimée (18).

9. Unité de construction selon l'une des revendications 2 à 5, caractérisée en ce que le refroidisseur (1) présente, sur chacun de ses deux grands bords situés sur les côtés du boîtier, une rainure (10, 11) dans laquelle s'engrène un épaulement (12, 13), moulé de façon correspondante, du couvercle (5).

10. Unité de construction selon l'une des revendications 1 à 9, caractérisée en ce que le bloc de puissance (14) est fixé sur la plus grande surface interne (2) du refroidisseur (1).

11. Unité de construction selon la revendication 10, caractérisée en ce que le fusible de sécurité (15) est disposé sur le côté du bloc de puissance (14) opposé à la plus petite surface intérieure (3) du refroidisseur.

12. Unité de construction selon la revendication 11, caractérisée en ce que le fusible de sécurité (15) est fixé sur deux barres coudées (16, 17) qui pénètrent, par l'intermédiaire d'une pièce isolante (27), dans une rainure de maintien (28) du refroidisseur (1).

13. Unité de construction selon l'une des revendications 10 à 12, caractérisée en ce que les barres électriques du composant de puissance sont disposées sur le côté du bloc de puissance (14) opposé à la surface intérieure (2) du refroidisseur (1).

14. Unité de construction selon l'une des revendications 1 à 13, caractérisée en ce que la carte imprimée (18) est disposée parallèlement à la paroi extérieure de boîtier (7) du couvercle (5) opposée à la plus grande paroi (2) du refroidisseur et est contigüe au couvercle.

15. Unité de construction selon la revendication 14, caractérisée en ce que des composants électroniques sont disposés sur le côté de la carte imprimée (18) opposé au couvercle (5).

16. Unité de construction selon les revendications 14 ou 15, caractérisée en ce que des pièces d'affichage et de réglage (30) sont disposées sur un bord (38) de la carte imprimée (18).

17. Unité de construction selon la revendication 16, caractérisée en ce que des éléments de connexion (29) sont prévus pour des connexions extérieures sur un autre bord (36) de la carte imprimée (18).

18. Unité de construction selon l'une des revendications 14 à 17, caractérisée en ce que le refroidisseur (1) présente, sur sa surface intérieure (3) limitant la carte imprimée (18), une rainure (21) pour le logement de la carte imprimée (18).

**19.** Unité de construction selon la revendication 1, caractérisée en ce que le refroidisseur (1) présente, sur la surface extérieure d'une paroi (3), des rainures (33) pour le logement de pièces de fixation (35).